Europäisches Patentamt

European Patent Office

Office européen des brevets

(11) Veröffentlichungsnummer: **0 481 117 A1**

## EUROPÄISCHE PATENTANMELDUNG

(21) Anmeldenummer: **90120006.3**

(22) Anmeldetag: **18.10.90**

(51) Int. Cl.5: **G06F 15/60**

(43) Veröffentlichungstag der Anmeldung:
**22.04.92 Patentblatt 92/17**

(84) Benannte Vertragsstaaten:
**AT BE CH DE DK ES FR GB GR IT LI LU NL SE**

(71) Anmelder: **SIEMENS AKTIENGESELLSCHAFT**
**Wittelsbacherplatz 2**
**W-8000 München 2(DE)**

(72) Erfinder: **Glockner, Gerhard, Dipl.-Math.**
**Sebastian-Kneipp-Strasse 6**
**W-8902 Neusäss(DE)**
Erfinder: **Jacoby, Konstantin, Dr.**
**Kirchweg 4sse 49**
**W-8039 Pucheim/Ort(DE)**
Erfinder: **Schiemann, Björn, Dipl.-Ing.**
**Josef-Maria-Lutz-Anger 16**
**W-8000 München 83(DE)**
Erfinder: **Thinschmidt, Hans, Dipl.-Ing.**
**Kreuzlingerstrasse 52c**
**W-8034 Germering(DE)**
Erfinder: **Pfeuffer, Evelyn, Dipl.-Phys.**
**Ellingerweg 57**
**W-8000 München(DE)**

(54) Verfahren zur Beschleunigung der Simulation beim rechnergestützten Entwurf elektronischer Schaltungen und Systeme.

(57) Es wird ein ereignisgesteuertes Verfahren zur mixed mode Simulation elektronischer Schaltungen und Systeme angegeben. Dabei ermöglicht die Verwendung eines speziellen Waveform Relaxation Algorithmus die gleichzeitige ereignisgesteuerte Simulation digitaler und analoger Schaltungteile auf unterschiedlichen Schaltungs-Beschreibungsebenen. Zur Steuerung des Simulationsverfahrens werden während der Simulation Ereignislisten generiert und verwaltet. Die Schnittstellenanpassung zwischen digitalen und analogen Schaltungsteilen geschieht mittels Koppelelementen, welche die Signaltransformation zwischen analogen und digitalen Signalfunktionen bewirken. Mit Hilfe des Verfahrens ist es möglich, komplexe elektronische Schaltungen, bei denen verschiedene Schaltungsteile auf verschiedenen Schaltungs-Beschreibungsebenen beschrieben und auf verschiedenen Simulationsebenen simuliert werden nach dem Prinzip der Ereignissteuerung auf äußerst effiziente Weise zu simulieren.

Mit der zunehmenden Höherintegration und der ständig steigenden Komplexität der Schaltkreise und Systeme nimmt auch der Anteil des Schaltungsentwurfs an den Entwicklungs- und Herstellungszeiten elektronischer Schaltkreise ständig zu. Aus diesem Grunde ist die Reduzierung der Entwurfszeiten ein wichtiges Ziel bei der Weiterentwicklung von Entwurfs- und Simulationsmethoden zur Entwicklung elektronischer Schaltkreise. Um die erforderliche Rechenzeit zur Durchführung von Schaltkreisen und Systemsimulationen bedeutend zu verringern, müssen sowohl die Simulationsverfahren als auch die zur Durchführung der Simulationen verwendete Hardware in geeigneter Weise weiterentwickelt werden.

Aus der Literatur sind verschiedene Verfahren zur Simulation elektronischer Schaltungen bekannt, die sich hinsichtlich der verwendeten Schaltungsbeschreibungsebenen und Simulationsebenen unterscheiden. Die Beschreibung eines Schaltungsmodells kann unterschiedlich fein sein. Entsprechend der Top Down Entwurfs-Philosophie werden verschiedene Beschreibungsebenen unterschieden. Diese Schaltungsbeschreibungsebenen sind entsprechenden Simulationsebenen zugeordnet. Eine Übersicht über die verschiedenartigen Schaltungsbeschreibungsebenen zeigt Tabelle 1.

Die Beschreibung einer Schaltung auf der Systemebene erfolgt mittels sog. HLL-Konstrukte, z.B. IF... THEN ... ELSE ... . Mit dieser funktionellen Beschreibung werden funktionelle Zusammenhänge des Schaltungsmodells mit diskreten Werten für Signale und Zeit simuliert. Die Signale können abstrakt als Variable realisiert werden. Beispiele für die Systemsimulation sind Warteschlangen, Simulation und Rechnerkommunikation.

**Tabelle 1: Übersicht der Darstellungsebenen**

| Simulationsebene / Darstellungsebene | Beschreibung |
|---|---|
| System (algorithmisch) | Funktionelle Beschreibung (A: = B + C; if (A) then X: = Y) |
| Register Transfer | Funktionelle Blöcke (ROM, ALU, RAM, CONTROL) |
| Logik (Gatter) | Logische Modelle Gatter z. B. NAND, AND, OR, NOT,... |
| (Switch) | Elektrische Modelle Transistoren als Schalter |
| (Timing) | Gatter z. B. NAND, AND, OR, NOT,... (Funktion und Verzögerung) Transistoren (grobe Modelle) |
| Circuit | Elektrische Modelle Transistoren (Transistormodelle) ($V_{DD}$) |
| Device | Numerische Modelle Geometrie, Physik |
| Process | Numerische Modelle Geometrie, Physik |

Die sog. Register-Transfersimulation wird auf der Blockebene oder Register-Transferebene durchgeführt. Die Schaltung wird in Blockfunktionen aufgelöst und das Zusammenspiel der Blöcke simuliert. Die Beschreibung erfolgt ebenfalls mittels HLL-Konstrukten oder mittels funktionellen Blöcken z.B. RAM, ALU, ROM. Zur Simulation wird die funktionelle Beschreibung des Eingangs/Ausgangsverhaltens mit diskreten und vorgegebenen Zeitbedingungen erstellt.

Die Beschreibung einer Schaltung auf Gatter-oder Logikebene erfolgt mittels funktioneller Blöcke, z.B. RAM, ROM, oder Gattern, wie z.B. NAND, AND, OR, NOT. Die logische Beschreibung dieser Blöcke oder Gatter enthält Boole'sche Gleichungen und Verzögerungszeiten. Es wird mit diskreten Werten (Boole'schen Variablen und diskreten Zuständen 0, 1, U, X ...) gearbeitet. Die Simulation des Zeitverhaltens von Logikschaltungen wird durch die Zuordnung von Verzögerungszeiten zu Gattern ermöglicht.

Die sog. Switch Level Ebene ist besonders für die Behandlung von MOS-Schaltungen geeignet. Die Beschreibung eines Schaltungsmodells auf dieser Ebene erfolgt mittels Transistoren als Schalter. Die Transistoren werden mittels einfacher algebraischer Gleichungen und Differenzengleichungen beschrieben. Für die Transistoren werden nur die Zustände leitend, gesperrt und offener Eingang berücksichtigt. Das entspricht den diskreten Signalwerten 0, 1 und X an den Knoten. Zusätzlich können aber auch unterschiedliche Signalstärken und spezifische MOS-Eigenschaften in Form von weiteren diskreten Zuständen behandelt werden.

Die Timing-Simulation wird nur bei MOS-Schaltungen mit rückkopplungsarmen Schaltungsstufen angewandt. Zur Beschreibung eines Schaltungsmodells auf dieser Ebene werden Gatter (Funktion und Verzögerung) oder grobe Modelle für Transistoren verwandt. Die Beschreibung erfolgt mittels Netzwerkgleichungen, Boole'schen Gleichungen und einem Zeitraster mit diskreten Werten. Netzwerkgleichungen werden nur näherungsweise gelöst.

Auf der Circuit oder Transistorebene wird die Schaltung durch elektrische Bauelemente (Widerstände, Kapazitäten, Transistoren ...) und deren Verknüpfung beschrieben. Die Beschreibung des Verhaltens erfolgt mittels zeitabhängiger, kontinuierlicher physikalischer Größen, z.B. I(t), U(t), Q(t). Als Transistormodell sind unterschiedliche Ersatzschaltungen wählbar, wodurch unterschiedliche Genaugkeitsstufen bei der Simulation erzielt werden können. Die Unterschiede liegen in der Idealisierung der Kennliniengleichungen, der Vernachlässigung der Koppelkapazitäten und der Vereinfachung der Rückführungen. Die mathematische Beschreibung der elektrischen Bauelemente besteht aus einem Satz von Differentialgleichungen, die die Kirchhoff'schen Gesetze berücksichtigen. Bei der Simulation wird eine Netzwerkanalyse mit kontinuierlichen Werten für Signale durchgeführt.

Bei der Simulation auf Device-Ebene oder Bauelemente-Ebene werden nur einzelne Bauelemente, wie Transistoren oder Dioden behandelt. Die Funktionsweise der Bauelemente wird mit partiellen Differentialgleichungen (Possion-und Halbleitergleichungen) beschrieben. Die Bauelemente werden durch genaue numerische Modelle dargestellt.

Die sog. Prozeß-Simulation dient der Untersuchung technologischer Bedingungen bei der Fertigung integrierter Schaltungen. Diese Simulationsebene bildet das untere Ende der Hierarchie von Simulationsebenen. Diffusion, Implantierung, Ätzen, Lackprofile und mehrdimensionale Effekte werden mit den Gleichungen der Halbleiterphysik beschrieben. Auf dieser Ebene der Schaltungsbeschreibung finden numerische Modelle und Methoden Anwendung.

Die beschriebenen Simulationsebenen gehören jeweils einer von zwei Kategorien an, welche als digitale bzw. analoge Simulation bezeichnet werden.

Die Digitalsimulation erstreckt sich über die System-, Register-Transfer- und Logik-Ebene. Switch- und Timing-Ebene können sowohl der Digital-Simulation als auch der Analog-Simulation zugeordnet werden (s. Tabelle 1). Mit Hilfe der Digital-Simulation kann der Anwender seinen Logikentwurf, d.h. die Übereinstimmung der Schaltungsfunktion mit vorgegebenen Boole'schen Funktionen verifizieren. Hierbei werden Signalverläufe mit Hilfe diskreter Zustände z.B. 0 und 1 und idealisierten Flanken berücksichtigt. Flankenunsicherheiten werden dem Zustand X (undefiniert) markiert. Die Einhaltung von Fan-in/Fan-out Bedingungen kann mit Hilfe von Lastfaktoren simuliert werden. Schließlich können in der Timing-Ebene Zeitbedingungen berücksichtigt werden, wodurch im Gegensatz zur statischen Simulation die Funktionsfähigkeit der Gesamtschaltung bei gegebenen Verzögerungszeiten von Teilschaltungen verfiziert werden kann. Bei zeitkritischen Schaltungsteilen kann der Entwickler unterschiedliche Analysen, z.B. Worst-Case-Pfad-Anlayse oder Minimax-Pfadanalyse durchführen.

Die Analogsimulation, welche auch elektrische Simulation genannt wird, erstreckt sich über die Circuit-, Device- und Prozeß-Ebene. Der Schaltungsentwickler versteht unter Analogsimulation in erster Linie die Simulation auf der Circuit-Ebene und ggf. auf der Switch- und Timing-Ebene (s. Tabelle 1). Ebenso wie bei der Digital-Simulation kann der Anwender mit Hilfe der Analog-Simulation sowohl die Funktion des Schaltungsentwurfs, d.h. die Übereinstimmung der logischen Schaltungsfunktion mit Hilfe vorgegebener Boole'scher Funktionen als auch das Zeitverhalten des Schaltungsentwurfs verifizieren. Im Gegensatz zur Digitalsimulation werden bei der Analogsimulation den Signalen jedoch kontinuierliche bzw. sehr fein abgestufte diskrete Zahlenwerte zugeordnet, weshalb man aus den in dieser Weise dargestellten analogen Signalen Flankensteilheiten und Pegelwerte ablesen kann. Ebenso sind aus den analogen Zeitfunktionen Zeitverzögerungen und Phasenverschiebungen direkt ablesbar.

Bei der Simulation einer Gesamtschaltung, die aus mehreren Teilschaltungen besteht, können die digitale und die analoge Simulationsart auf verschiedene Art und Weisen miteinander verbunden werden. Deshalb unterscheidet man je nach dem Grad der Überdeckung der verschiedenen Simulationsebenen während eines Simulationslaufes die Simulationsarten Einebenensimulation (einfache Simulation), Mehrebenensimulation (Multi-Level-Simulation) bzw. Mixed-Mode-Simulation.

Bei der Einebenensimulation wird die zu simulierende Schaltung, die auch hierarchisch gegliedert sein kann, auf ein Simulationsmodell in einer Simulationsebene abgebildet. Dabei wird die Gesamtschaltung durchgehend auf einer einzigen Schaltungsbeschreibungsebene beschrieben. Der Simulator arbeitet bei der Einebenensimulation lediglich auf dieser einen Simulationsebene. Wegen der Beschränkung auf eine Schaltungsbeschreibungsebene und eine Simulationsebene wird für die Einebenen simulation lediglich eine Bibliothek benötigt.

Bei der Mehrebenensimulation wird die zu simulierende, auch hierarchisch gegliederte Schaltung wahlweise auf unterschiedliche Simulationsmodelle abgebildet, die eine oder meherere Ebenen umfassen können. Hierbei arbeitet der Simulator mit genau einer Beschreibungssprache, mit der die Schaltung auf einer oder meheren verwandten Ebenen beschrieben werden kann. Der Simulationslauf bewegt sich in einer oder in mehreren durch die Beschreibungssprache verwandten Ebenen. So kann z.B. mit Hilfe einer Beschreibungssprache eine Schaltung sowohl auf der Register-Transfer-als auch auf der Logik-Ebene beschrieben und simuliert werden.

Bei der Mixed-Mode-Simulation wird schließlich eine zu simulierende, auch hierarchisch gegliederte Schaltung auf Simulationsmodelle in unterschiedlichen Ebenen abgebildet. Unterschiedliche Schaltungsteile können unterschiedlichen Simulationsebenen zugeordnet werden. Diese Schaltungsteile können der hierarchischen Gliederung oder z.B. einem kritischen Pfad entsprechen. Bei der Mixed Mode Simulation arbeitet der Simulator auf allen Ebenen gleichzeitig. Mixed Mode Simulation ist stets eine Kombination von Logik- und Circuit-Simulation. Innerhalb eines Simulationslaufs sind einzelne Schaltungsteile mit unterschiedlicher Genauigkeit modelliert und auf unterschiedlichen Schaltungsbeschreibungsebenen beschrieben. Deshalb werden nebeneinander gleichzeitig mehrere Bibliotheken für die verschiedenen Schaltungs-Beschreibungs- und Simulationsebenen verwendet.

Neben den Kriterien der Schaltungsbeschreibungs- und Simulationsebenen sind für die Charakterisierung eines Simulators aber auch noch die Ablaufsteuerung und die Berechnung der Elementfunktionen wichtig. Bei der Simulation einer elektrischen Schaltung sind jene Zeitpunkte besonders wichtig, bei denen eine Änderung des Signalzustandes auftritt oder zu erwarten ist. All diese Zeitpunkte bilden entweder ein heterogenes oder ein homogenes Zeitraster. Bei einem heterogenen Zeitraster sind die zeitlichen Abstände zweier aufeinander folgender Rasterpunkte unterschiedlich, beim homogenen Zeitraster sind sie hingegen gleich.

Hinsichtlich der Berechnung von Elementfunktionen gibt es drei Möglichkeiten, die Berechnung dieser Elementfunktionen anzustoßen:
Bei der Zeitsteuerung gibt jeder zu betrachtende Zeitpunkt den Anstoß für eine Berechnung aller Elementfunktionen und damit des gesamten Modellzustandes.

Bei der Datenflußsteuerung wird für jeden möglichen Zeitpunkt das komplette Modell durchgerechnet. Ein Element des Simulationsmodells wird unabhängig vom Signalverlauf immer dann berechnet, wenn alle Eingänge mit gültigen Werten versorgt sind. Für jeden Zeitpunkt muß der komplette Datensatz aufgebaut und zwischengespeichert werden.

Im Gegensatz zu den recht aufwendigen Verfahren der Zeitsteuerung und der Datenflußsteuerung werden bei der sog. Ereignissteuerung nur die Elementfunktionen derjenigen Elemente berechnet, die für den betrachteten Zeitpunkt relevant sind, d.h. an deren Eingängen eine Änderung der Eingangssignale vorliegt.

Unter dem Aspekt der Simulationsbeschleunigung ist die Implementierung eines Simulators unter Zugrundelegung der sog. Ereignissteuerung auf einer dafür optimierten Architektur am günstigsten.

Der Erfindung liegt die Aufgabe zugrunde, ein möglichst effizientes Verfahren zur Mixed Mode Simulation elektrischer Schaltungen auf der Grundlage der Ereignissteuerung anzugeben. Diese Aufgabe wird durch ein Verfahren zur Simulation elektronischer Schaltungen und Systeme mit Merkmalen nach Anspruch 1 gelöst.

Die Erfindung wird im folgenden anhand eines bevorzugten Ausführungsbeispieles erläutert.

| | |
|---|---|
| Figur 1 | zeigt den Ablauf, den Kontrollfluß und die Datenzugriffe des ereignisgesteuerten Simulationsverfahrens. |
| Figur 2 | zeigt die Iterationshierarchie der Waveform-Relaxation. |
| Figur 3 | zeigt eine Veranschaulichung von Ereignisketten in der ereignisgesteuerten Simulation. |
| Figur 4 | zeigt eine Veranschaulichung des Listensystems EVENTLIST für die Ereignissteuerung. |

Figur 5    zeigt die Schnittstellenanpassung zwischen digital- und analog simulierten Schaltungsteilen mit Hilfe von Koppelelementen.

Figur 6    zeigt die Schnittstellenanpassung zwischen einem Ausgang eines digital simulierten Schaltungselements und einem Eingang eines analog simulierten Schaltungselements mit Hilfe eines Generators.

Figur 7    zeigt die Schnittstellenanpassung zwischen einem Ausgang eines analog simulierten Schaltungselements und einem Eingang eines digital simulierten Schaltungselements mit Hilfe eines Komparators.

Figur 8    zeigt die Einfügung von Koppelelementen bei der Modulierung von Leitungswiderständen und Kapazitäten durch diskrete Bauelemente.

Figur 9    zeigt die Einfügung von Koppelelementen bei Verzweigungen eines Ausgangs eines digital simulierten Schaltungselements auf Eingänge von analog simulierten

| Modellebene | Beschreibungs-mittel, Gleichungen | Komplexität (Anzahl der Transistoren) |
|---|---|---|
| System | Funktionelle Beschreibung in algorithmischer Form:<br>•<br>•<br>•<br>A : = B+C<br>if (A) then<br>X : = Y + Z fi;<br>•<br>• | über $10^5$ |
| Register-Transfer | Funktionelle Blöcke (ALU, RAM, Register,...) | über $10^4$ |
| Logic-Gate (Transistor-Switch) | Logisches Modell, Gatter (Tabel-lenauswertung) | $10^3$ bis $10^5$ |
| Timing | Gatter, elektri-sche Modelle | $10^2$ bis $10^4$ |
| Circuit | elektrische Modelle, Systeme aus nichtlin. Gleichungen u. gew. Differntial-gleichungen<br>——5V<br>——0V | $10^1$ bis $10^3$ |

Tabelle 2: Modell- und Sirulationshierarchie

bzw. digital simulierten Schaltungselementen.

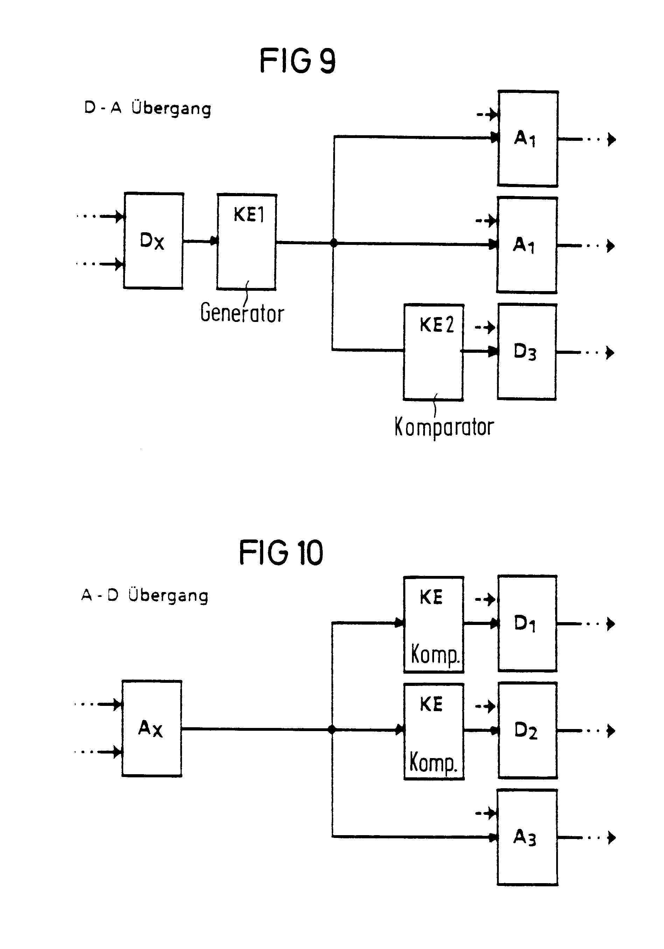

Figur 10     zeigt die Einfügung von Koppelelementen bei Verzweigungen eines Ausgangs eines analog simulierten Schaltungselements auf Eingänge von analog bzw. digital simulierten Schaltungselementen.

Der Entwurf von Schaltungen und seine Verifikation wird mit Hilfe von Simulationen auf den in Tabelle 2 zusammengefaßten Modellebenen durchgeführt. Dabei stellt die Systemebene die höchste Abstraktionsstufe und die Circuitebene die tiefste Abstraktionsstufe der angegebenen Hierarchie dar. Ziel der Simulation auf den genannten Modellebenen ist die Kenntnis des Verhaltens einer zu untersuchenden Schaltung in Abhängigkeit von Eingangsgrößen (Stimuli, Schaltungsparametern) und (unterhalb der Systemebene) von der Zeit. Ein wesentliches Unterscheidungsmerkmal zwischen den Modellebenen ist die Art der Zeitbehandlung: Der Register-Transfer-Ebene sowie insbesondere der Logikebene ist im allgemeinen ein festes diskretes Zeitraster zugrundegelegt, über dem die möglichen Zustandsänderungen betrachtet werden, während die Timing-Ebene und die Circuit-Ebene die möglichen Zustandsänderungen als Funktionen über der kontinuierlichen Zeitachse wiedergeben. Zur Beschreibung des bevorzugten Ausführungsbeispiels werden deshalb die Circuit-Ebene und die Logik-Ebene repräsentativ für die angesprochenen Arten der Zeitbehandlung beschrieben.

Die Ablaufstruktur der ereignisgesteuerten Simulation kann im wesentlichen mit Hilfe der folgenden sieben Simulationsschritte dargestellt werden:

S1 : Einlesen der Anfangsdaten,
S2 : Einlesen des nächsten Ereignisses
S3 : Auswerten eines Elementes
S4 : Untersuchung des Elementes auf geänderte Ausgangszustände
S5 : Aktualisieren der an die geänderten Ausgänge angeschlossenen Elemente,
S6 : Behandeln dieser Folgeereignisse, Rückkehr nach S2 oder Übergang nach S7,
S7 : Ausgabe der Ergebnisdaten.

Dabei wird auf die folgenden Datenkategorien zugegriffen:

D1 : Elementdaten,
D2 : Netzliste,
D3 : Ereignislistensystem (EVENTLIST)

Zu Beginn der Simulation sind D1 und D2 zunächst zu laden (S1), um dann ausgehend von X2 mit S4, S5, S6, S2 die Startbelegung des Ereignislistensystems EVENTLIST zu generieren. Ein Ereigniszyklus hat dann seinen Startpunkt stets bei X1. Während der Simulation werden dann dynamisch (d.h. in Abhängigkeit des Aktivitätsprofils des zu simulierenden Schaltungssystems) die Ereigniszyklen (S2, S3, S4, S5, S6) erzeugt und nach einer durch das Ereignislistensytem EVENTLIST repräsentierten partiellen Ordnung der Ereignisse abgearbeitet.

Tabelle 3:

| Circuit-Simulation program CEVENT | Simulations-schritte | Logiksimulation program LEVENT |
|---|---|---|
| Zeilen 2, 3 | S2 | Zeilen 2, 3 |
| Zeilen 4, 5 | S3 | Zeilen 4, 5, 6 |
| Zeilen 6, 16 | S4 | Zeilen 7, 8 |
| Zeilen 7, 17, 18 | S5 | Zeilen 9, 10 |
| Zeilen 8, 9, 10, 11, 19 | S6 | Zeilen 11, 12, 12 |

Tabelle 3: Zuordnung der Simulationsschritte

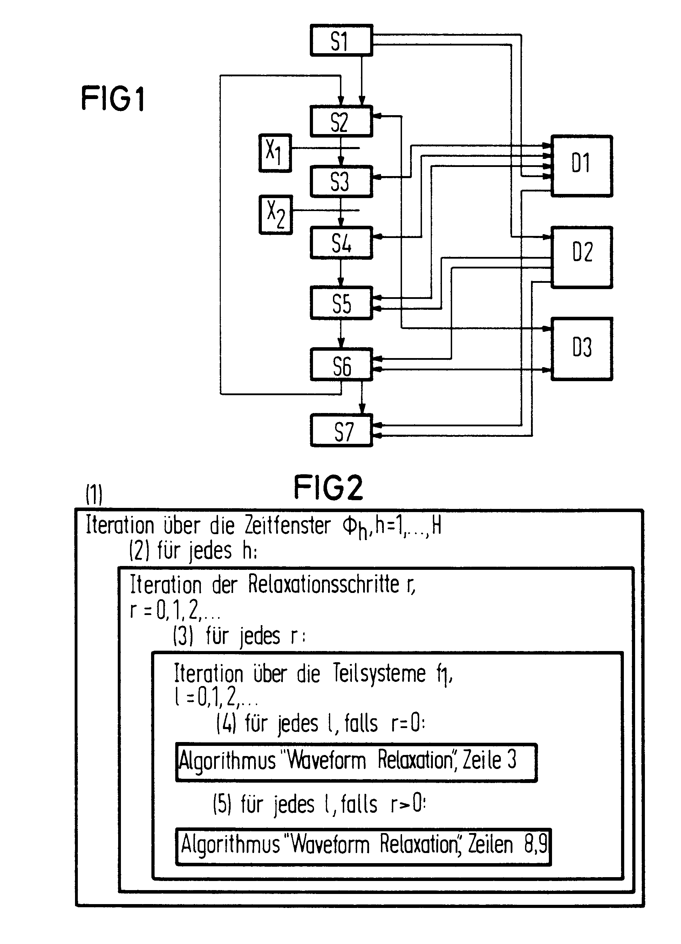

Tabelle 3 gibt eine Zuordnung der einzelnen Anweisungen zu den Simulationsschritten S2, S3, S4, S5, S6 wieder. Der letzte Ereigniszyklus einer Simulation ist schließlich beendet, wenn das in D3 abgelegte Ereignis Listensystem EVENTLIST leer ist. Die Ergebnisausgabe wird dann von X1 angestoßen und von S7 ausgeführt. Folgende Eigenschaften des Kontrollflusses und der Datenzugriffe sind dabei für eine Parallelisierung und Simulationsbeschleunigung besonders bedeutsam:
Der Simulationsschritt S3 greift nur auf die Datenkategorie D1 zu und kann unabhängig von S4, S5, S6 und S2 ausgeführt werden. Ferner wirkt eine Partitionierung des zu simulierenden Schaltungssystems zunächst nur auf S4, S5, S6 und S2, was für eine Zuordnung von parallel arbeitenden Pipelines zu dieser Folge von Simulationsschritten ausgenutzt werden kann. Die Auswertung der Ereignisse im Simulationsschritt S3 kann getrennt davon auf einer geeigneten Anzahl spezieller Auswertungseinheiten erfolgen. An den mit X1 bzw. X2 in Figur 1 gekennzeichneten Schnittstellen des Kontrollflusses der ereignisgesteuerten Simulation besteht prinzipiell die Möglichkeit, eine Task Verteilung vorzunehmen, die ein Gleichgewicht bei der Ausführung der einzelnen Simulationsschritte S2, S3, S4, S5 und S6 gewährleistet

Im folgenden wird nun die Durchführung der Simulation auf der Circuitebene ausführlich erläutert.

Zur Beschreibung des elektrischen Verhaltens einer Schaltung auf der Circuitebene werden folgende Voraussetzungen gemacht:

- eine Schaltung ist als System von 2-Polelementen (Widerstände, Kapazitäten, Induktivitäten, unabhängige Spannungs- und Stromquellen, spannungsgesteuerte bzw. stromgesteuerte Spannungs- und Stromquellen) gegeben.
- Die 2-Polelemente werden durch sog. charakteristische Gleichungen für die ihnen zuzuordnenden Kantenspannungen oder Kantenströme modelliert (A.L. San Giovanni-Vincentelli, Circuit Simulation, in "Computer Design Aids for VLSI Circuits" Ed.: T. Antoguetti, D.O. Paderson, H. deMan), NATO ASI Series E: Applied Siences, Nr. 48, 1980, 19 bis 112). Komplexere Schaltungselemente werden durch Ersatzschaltungen aus 2-Polelementen dargestellt (z.B. Shichman Hodges für MOSFETs), (Shichman Hodges, "Modelling and Simulation of Insulated Gate Field-Effect Transistor Switching Circuits", IEEE Journal of Solid State Circuits, vol. SC-3, Nr. 3, 1968, 285 - 289).
- Die Vernetzung der 2-Polelemente in einer Schaltung wird als Kopplung der entsprechenden charakteristischen Gleichungen mittels der beiden Kirchhoffschen Gesetze für die Kantenspannungen und die Kantenströme dargestellt (R.K. Brayton, J.K. Moser, A Theory of non-linear Networks, I & II, Quart. Appl. Math., vol. 22, Nr. 1, 1 bis 33, und vol. 22, Nr. 2, 81 bis 104, 1964).

Zur Gewinnung eines Gleichungssystems zur Beschreibung des elektrischen Verhaltens aus den obigen Voraussetzungen werden im wesentlichen zwei verschiedene Ansätze verwendet, welche sich in der Wahl der Zustandsvariablen unterscheiden:

- MNA: Modified Nodal Approach (C.Ho, A.E.Ruehli, P.A.Brennan, "The Modified Nodal Approach to Network Analysis", IEEE Transactions on Circuits and Systems, vol. CAS.-22, June 1975, 504 bis 509) und
- STA: Sparse Tableau Approach (G.D.Hachtel, R.K.Brayton, F.G.Gustavson, "The Sparse Tableau Approach to Network Analysis", IEEE Trans. on Circuit Theory, vol. CT-18, Jan. 1971, 101-113).

Beide Ansätze führen auf Systeme impliziter gewöhnlicher Differentialgleichungen der Form

(1a) $\quad f(dx/dt,x,z,t) = 0, \; t \in [0,T],$

(1b) $\quad g(x,z,t) = 0, \; t \in [0,T],$

die mit einer geeigneten Wahl von Anfangsbedingungen der Form

(2) $\quad x(0) = a$

unter gewissen Differenzierbarkeitsvoraussetzungen eindeutig bestimmte Lösungsfunktionen der Vektoren X und Z

(3) $\quad x^* \in C^1[0,T], \; z^* \in C[0,T]$

der Zustandsvariablen besitzen. Bei MOS-Schaltungen reduziert sich das System von Differentialgleichungen auf ein implizites System gewöhnlicher Differentialgleichungen (K.Jacoby, die 2-parametrige Waveform Relaxation und ihre Anwendung in der VLSI-Simulation, Dissertation, mathematisches Institut der Universität München, München April 1987). Die Bestimmung von Näherungslösungen für die exakten Lösungen dieser Differentialgleichungssysteme auf einer dynamisch erzeugten Folge von Zeitpunkten heißt Transientenanalyse. Für die auf Systeme von Differentialgleichungen gestützte Transientenanalyse haben sich die im Simulationsprogramm SPICE-2 (L. W.Nagel, Spice 2, A Computer Programm to Simulate Semiconductor Circuits, University of Cal., Berkeley, CA, USA, May 1975, Erl Memorandum Nr. Erl - M520) eingesetzten impliziten Backward Differentiation Formulas (BDF) von Brayton et al (Brayton 1972) bewährt. Die Transientenanalyse wird in Spice 2 mit drei Schritten durchgeführt.

- Diskretisierung der Zeitableitungen am aktuellen Zeitpunkt,

- Lösung des dadurch aus dem zu lösenden Differentialgleichungssystem resultierenden nicht linearen Gleichungssystems mit dem Newton Verfahren,
- Abschätzung des lokalen Abschneidefehlers und Bestimmung des nächsten Zeitpunktes.

Diese drei Schritte werden im folgenden weiter präzisiert, um die Einbettung des BDF-Verfahrens in das Verfahren der ereignisgesteuerten Mixed-Mode-Simulation auf der Circuit-Ebene beschreiben zu können. Die allgemeinen Grundlagen des BDF-Verfahrens ergeben sich aus (Brayton 1972).

Sei $t_{n+1}$ bereits als aktueller Zeitpunkt der Zeitpunktfolge der Näherungslösung bestimmt. Ferner seien die Näherungslösungen x0, ... xn an den Zeitpunkten t0, ...tn als bekannt vorausgesetzt. Die BDF-K-ter Ordnung (k = maximum von n,6) für die Bestimmung der Näherungslösung $x_{n+1}$ bei $t_{n+1}$ können mit Hilfe des eindeutig durch die k+1 Wertepaare $(t_{n-k}, x_{n-k})$, ..., $(t_n, x_n)$ bestimmten Interpolationspolynoms K-ter Ordnung

$$(4) \qquad P(t;k,n) := \sum_{i=1}^{k+1} p_i(t;k,n) \cdot x_{n+1-i}$$

ausgedrückt werden. Dabei sind die Koeffizienten $p_i(t;k,n)$ Polynomfunktionen der Ordnung k, so daß gilt: $P_i(t_{n+1-j};k,n) = \delta_{ij}$ für i,j = 1, ... k+1). In analoger Weise sind ferner die Interpolationspolynome $P(t;k,n+1)$ und $P(t;k+1,n+1)$ zu definieren. Im ersten Schritt wird um die Zeitableitung im Gleichungssystem ( 1 ) an der Stelle $t_{n-1}$ mit Hilfe des Polynoms $P(t_{n+1});k,n+1)$ diskretisiert; man erhält damit für $x_{n+1}$ das nichtlineare Gleichungssystem

$$f_{n+1}(x_{n+1}) := f(P(t_{n+1};k,n+1),x_{n+1},t_{n+1}) = 0 \qquad (5)$$

zur Lösung des Systems ( 5) wird dann im zweiten Schritt das Newton Verfahren

$$(6) \quad [\frac{\partial}{\partial x} f_{n+1}(x_{n+1}^{[j]})](x_{n+1}^{[j+1]} - x_{n+1}^{[j]}) = - f_{n+1}(x_{n+1}^{[j]}) ,$$

$$j = 0, 1, 2, ... ,$$

mit der Startlösung

$$(7) \qquad x_{n+1}^{[0]} := x_{n+1}^p := P(t_{n+1};k,n)$$

angewendet. Das Interpolationspolynom $P(t;k,n)$ dient also als Prädiktorformel für $x_{n+1}$. Das System ( 6) stellt dann eine Folge von linearen Gleichungssystemen dar, die mit direkten Verfahren (etwa mit der LU-Zerlegung) gelöst werden, bis ein Abbruchkriterium der Form

$$(8) \qquad \| x_{n+1}^{[j+1]} - x_{n+1}^{[j]} \| < \varepsilon_N \ , \ \varepsilon_N \ll 1 ,$$

erfüllt ist; es wird dann

$$(9) \qquad x_{n+1} := x_{n+1}^{[j+1]}$$

gesetzt. Schließlich wird im dritten Schritt aus den Steigungen der Interpolationspolynome $P(t;k,n+1)$ und $P(t;k+1,n+1)$ eine Schätzung für den lokalen Abschneidefehler $E_k(t,h)$ bei $t=t_{n+1}$ gewonnen und daraus die Länge $h_{n+1}$ des nächsten Zeitschrittes bestimmt:

$$E_k(t_{n+1}, h) := h \cdot [\frac{d}{dt} P(t_{n+1}; k+1, n+1) - \frac{d}{dt} P(t_{n+1}; k, n+1)],$$

$$\Delta t_{n+1} := \max \{ \Delta t \in [0, \Delta t_{max}] : E_k(t_{n+1}, \Delta t) \leq \varepsilon_E \},$$

$$t_{n+2} := t_{n+1} + \Delta t_{n+1} \qquad (10)$$

Eine Alternative zur direkten Lösung großer linearer und nicht linearer Gleichungssysteme ist durch Relaxationsverfahren wie das Gauss-Seidel-Verfahren, das SOR-Verfahren und das Gauss-Jacoby-Verfahren gegeben. Ihre Konvergenzgeschwindigkeit ist mindestens linear, und sie können im Gegensatz zum Computer Verfahren mit beliebigen Startnäherungen durchgeführt werden. Die Verallgemeinerung dieser Verfahren zur Berechnung von Lösungen von Differentialgleichungssystemen wird als Waveform Relaxation bezeichnet. Im folgenden wird diese Methode und speziell ihre Anwendung innerhalb eines Verfahrens zur ereignisgesteuerten Simulation auf der Circuit-Ebene geschrieben.

Die Waveform-Relaxation basiert auf einer geeigneten Partitionierung des Anfangswertproblems ( 1 ) in gekoppelte Teilanfangsprobleme der Form

$$f_l(dx_1/dt, ..., dx_l/dt, ..., dx_L/dt, x_1, ..., x_l, ..., x_L, t) = 0$$

$$\text{auf } [0, T] \quad \text{mit } x_l(0) = a_l,$$

$$\text{für } l = 1, ..., L, \qquad (11)$$

denen eine entsprechende Partitionierung

$$(12) \qquad x = (x_l, ..., x_l, ..., x_L)$$

des Zustandsvektors x zugeordnet ist. Bezüglich einer derartigen Partitionierung wird dann auf dem Raum der stückweisen stetig differenzierbaren Funktionen über dem Intervall (O, T) folgender Relaxationsalgorithmus ausgeführt:

```
(* (13)
r: Iterationszähler für die Waveform Relaxation
l: Iterationszähler für die Teilsysteme,
ε_R: Abbruchschranke für die Relaxation,
x_l: Komponente (Teilvektor) des Zustandsvektors x, die dem
     l-ten Teilsystem f_l (...) = 0
     zugeordnet ist.*)


1       r: = 0
(* Bestimmung der Startlösung auf (O,T)*)
2       for l: = 1 (one) to L do
3       choose x_l(0) piecewise continously differentiable on
        (O, T) where x_l(o) = a_l;
4       od:
5       repeat



6       r: = r+1;
(* Relaxationsschritt r*)
7       for l : = 1 (one) to L do
8       solve with respect to x_l(r) on (O,T):
9
```

$$f_l \left( dx_l^{[r]}/dt, \dots, dx_l^{[r]}/dt, dx_{l+1}^{[r-1]}/dt, \dots, dx_L^{[r-1]}/dt, x_1^{[r]}, \dots, x_l^{[r]}, \right.$$

$$\left. x_{l+1}^{[r-1]}, \dots, x_L^{[r-1]}, t \right) = 0 \quad \text{where} \quad x_l^{[r]}(0) = a_l ;$$

```
10      od;
(* Abbruchkriterium*)
11 until
```

$$\left( \max_{t \in [0,T]} \quad \max_{\ell = 1, \dots, L} \quad \| x_l^{[r]}(t) - x_l^{[r-1]}(t) \| \le \varepsilon_R \right) ;$$

Eine Analyse der Konvergenzeigenschaften sowie eine optimierende Modifikation der Waveform der Relaxation die mit Hilfe der Konstruktion geeigneter Relaxationsparameter insbesondere die Konvergenzprobleme der Waveform Relaxation bei der Behandlung von Schaltungssystemen mit globalen Rückkopplungen behebt, wird in (Jacoby 1987) gegeben. Für die weiteren Überlegungen sind die folgenden Eigenschaften wesentlich:

- Für die Konvergenz der Waveform Relaxation ist u.a. eine geeignete Beschränkung der Länge des zugrundeliegenden Zeitintervalls (O, T) notwendig (Jacoby 1987);
- Die Konvergenzgeschwindigkeit der Waveform Relaxation zeigt eine lineare Abhängigkeit von der Anzahl L der Teilsysteme und von der Länge T des Zeitintervalls (Jacoby 1987).

Die zweite Eigenschaft führt mit Hilfe einer Zerlegung des Intervalls (O, T) in sog. Zeitfenster der Form

$$\phi_h := [T_{h-1}, T_h] \text{ für } h = 1, \dots, H \text{ mit}$$

$$(14) \qquad 0 = T_0 < T_1 < \dots < T_h < \dots < T_H = T \text{ und}$$

$$\Delta t_{max} < T_h - T_{h-1} < \varepsilon_\phi$$

zu einer beschleunigten Version der Waveform Relaxation, die durch folgenden Algorithmus (Jakoby 1987), (A.R.Newton, The Simulation of Large Scale Integrated Circuits, University of Cal., Berkeley, CA, USA, July 1978, Erl Memorandum Nr. Erlm 78/52) gegeben ist.

```
(*      h:      Iterationszähler für Zeitfenster,
        φ_h:    Zeitfenster gemäß
1       h: =  0;
2       x: =  a;                                          (15)
3       for h: = 1 (one) to H do
4       a_h: = x(T_{h-1});
5       execute Algorithm ( 13  ) on window φ_h with respect to
        initial value a_h at t = T_{h-1};
6
```

$$x\Big|_{\phi_h} := x^{[r]}\Big|_{\phi_h};$$

```
(*      x^(r) erfüllt das Abbruchkriterium aus Algorithmus
        ( 13  ), Zeile 11 *)
7       od.
```

Algorithmus (15) und der dort in Zeile 5 eingebettete Algorithmus (13) lassen die in Figur (2) erkennbaren drei hierarchischen gestaffelten Iterationen erkennen. Für r>0 implizieren dabei die drei in Figur (2) dargestellten Iterationen der Waveform Relaxation, das in Schritt 5 die Näherungslösungen

$$x_j^{[r]}\Big|_{\phi_h}$$

für die Komponenten $x_j$ des Zustandsvektors x als Eingangsparameter (Fan in Parameter) für das l-te Teilanfangsproblem im r-ten Relaxationsschritt auf dem Zeitfenster $\phi_h$ wirken, falls gilt: $j \in F_{in}(1)$
wobei

$$(16) \qquad F_{in}(l) := \{j \in \{1, \dots, l-1\} : \left(\frac{\partial f_l}{\partial \dot{x}_j}\right)^2 + \left(\frac{\partial f_l}{\partial x_j}\right)^2 \neq 0 \}$$

die Indexmenge der Fan in Teilanfangsprobleme des l-ten Teilsystems bezeichnet. Die Ausführung des Schrittes 5 aus Figur (2) kann somit nur dann eine Näherungslösung

$$X_\ell^{[r]}\Big|_{\phi_h} \text{ für } X_\ell\Big|_{\phi_h}$$

mit

$$(17) \qquad \max_{t \in \phi_h} \quad \| x_l^{[r]}(t) - x_l^{[r-1]}(t) \| \quad > \quad \varepsilon_R$$

liefern, falls zuvor mindestens einer der Eingangsparameter eine wesentliche Änderung erfahren hatte, d.h.

$$(18) \qquad \exists_{j \in F_{in}(l)} \quad : \quad \max_{t \in \phi_h} \quad \| x_j^{[r]}(t) - x_l^{[r-1]}(t) \| \quad > \quad \varepsilon_R \, .$$

analog zur Definition von $F_{in}(1)$ definieren die drei Iterationen aus Figur (2) nun diejenigen Teilanfangswertprobleme für die die in Schritt 5 gerade erzeugte Näherungslösung des l-ten Teilanfangswertproblems einen Eingangsparameter bildet. Diese sind durch die Indizes

$(19) \quad j \in F_{out}(1)$

gegeben, wobei

$$(20) \qquad F_{out}(l) := \{ j \in \{ l+1, \ldots, L \} : \left( \frac{\partial f_j}{\partial \dot{x}_l} \right)^2 + \left( \frac{\partial f_j}{\partial x_l} \right)^2 \neq 0 \}$$

die Indexmenge der Fan-out-Teilanfangsprobleme des l-ten Teilsystems bezeichnet. Für den auf dem Zeitfenster $\phi_h$ bei $r = 0$ auszuführenden Schritt 4 aus Figur (2) liefert das BDF-Verfahren aufgrund seiner Anwendung in Schritt 5 (bezogen auf das Zeitfenster $\phi_{h-1}$) ein geeignetes Hilfsmittel. Dazu setzt man das Interpolationspolinom $P_1 (t; k, n+1)$, welches durch die Näherungslösungen für

$$X_\ell\Big|_{\phi_{h-1}}$$

an den zuletzt im BDF-Verfahren verwendeten Zeitpunkten $\{t_{n-k} \ldots, t_{n+1}\} \in \phi_{h-1}$ $(t_{n+1} = T_{h-1})$ eindeutig bestimmt ist, auf das Zeitfenster $\phi_h$ fort und definiert:

$(21) \quad x_1^{[0]}(t) := P_1 (t; k, n+1)$ für $t \in \phi_h$ .

Falls eine Abschätzung des lokalen Abschneidefehlers auf gemäß (18) dem Abbruchkriterium für die Waveform Relaxation noch nicht genügt, d.h.

$(22) \quad E_k(T_h, T_h - T_{h-1}) > \epsilon_R$ ,

so ist die Näherungslösung $X_\ell^{[0]}|_{\phi_h}$ auf $\phi_h$ durch weitere Iterationen der Waveform Relaxation $(r > 0)$ zu verbessern.

Die oben vorgestellte Interpretation des Schrittes 5 aus Figur (2) als Prozeß, der auf lokalen Zeitintervallen (den Zeitfenstern) Näherungslösungen von Teilsystemen in Abhängigkeit von Änderungen derjenigen Eingangsparameter liefert, welche durch die der Waveform Relaxation zugrundeliegenden Partitionierung des gegebenen Anfangswertproblems bestimmt werden, sowie die Interpretation des Schrittes 4 aus Figur (2) als Prozeß der Näherungslösungen von Teilsystemen durch polynomiale Extrapolation der auf dem voranstehenden Zeitintervall gewonnener Lösung erzeugt, führt in natürlicher Weise auf den Begriff des Ereignisses. Dazu werden Ereignisse mit der (im Vergleich zu Schritt 4) aufwendigen Durchführung von Schritt 5 aus Figur (2) identifiziert, wobei Schritt 5 nur dann ausgeführt wird, wenn die Kopplungseigenschafen des entsprechenden Teilsystems es erfordern. Andernfalls genügt es nur Schritt 4 anzuwenden. Derartige Ereignisse erhalten durch die drei Iterationsparameter $\phi_h$, r, und l aus Figur (2) eindeutige Kennzeichnungen, die als Schlüssel für eine die drei Iterationen aus Figur (2) effizient ersetzende Ereignissteuerung (event scheduling) dienen.

Eine formale Definition des Begriffs Ereignis erhält man durch ein (Unter-Programm) folgender Bauart.

```
program CEVENT (K):
begin
A                                        (23)
end.
```

Der Parameter K heißt Ereigniskennung, das Programmstück A heißt Ereignisauswertung. Es gelten dafür folgende Definitionen:

K: = ($\phi_h$, r, l, b)      (24)

wobei $\phi_h$, r,l gemäß Figur (2) erklärt sind und und A:

1     **if** b **then**

2     **get** $(F_{in}(l), F_{out}(l))$ ;                    (25)

3     **get** $(x|_{\phi_{h-1}}, (x_j^{[r]}|_{\phi_h})_{j \in F_{in}(l)}, x_l^{[r-1]}|_{\phi_h})$ ;

4     **solve** with respect to $x_l^{[r]}$ on $\phi_h$ :

      ( * BDF-method *)

5     $f_l\,(dx_1^{[r]}/dt, \dots, dx_l^{[r]}/dt, dx_{l+1}^{[r-1]}/dt, \dots, dx_L^{[r-1]}/dt, x_1^{[r]}, \dots, x_l^{[r]},$

         $x_{l+1}^{[r-1]}, \dots, x_L^{[r-1]}, t)\;\;=\;\;0$ ,

      where $x_l^{[r]}(T_{h-1}) = x_l(T_{h-1})$ ;

6     **if** $(\;\|\,x_l^{[r]}|_{\phi_h} - x_l^{[r-1]}|_{\phi_h}\,\|_\infty > \varepsilon_R\;)$ **then**

7       **store** $(x_l^{[r]}|_{\phi_h})$;

8       **for** $j \in F_{out}(l)$ **do**

9       **execute** SCHEDULE(CEVENT , $(\phi_h, r, j, \underline{true})$) ;

10      **od**:

11      **execute** SCHEDULE(CEVENT , $(\phi_h, r+1, l, \underline{true})$) ;

12    **else**

13       $b ::= \underline{false}$ ;                   (noch (25))

14       $x_l|_{\phi_h} ::= x_l^{[r]}|_{\phi_h}$ ;

15       **store** $(\,x_l|_{\phi_h})$;

      ( * estimation of the local truncation error *)

16       $i ::= \min\{j \in N:\; h+j \le H\;\wedge\;E_k(T_{h+j}, T_{h+j}-T_h) > \varepsilon_R\}$;

17       $x_l^{[o]}|_{\phi_{h+i}} ::= P_l(\,\cdot\,;k, n+1)|_{\phi_{h+i}}$ ;

18       **store** $(\,x_l^{[o]}|_{\phi_{h+i}})$;

19       **execute** SCHEDULE(CEVENT , $(\phi_{h+i}, 1, l, \underline{true})$) ;

20    **fi**; (* 6 *)

21    **fi**; (* 1 *)

Die von einem gemäß (23), ... , (25) definierten Ereignis mit der Kennung K = ($\phi_h$, r, l, b) erzeugten Folgeereignisse (Fan-out EVENTS) (vgl. Zeilen 8, 11, 19 in Programmstück A) wirken in drei Richtungen, die sich in den zugehörigen Ereigniskennungen niederschlagen. Eine Veranschaulichung dieser Wirkungsrichtungen gibt Figur (3). Die Einordnung dieser Folgeereignisse in eine Verarbeitungsreihenfolge, die im Sinne der Iterationen aus Figur (2) korrekt ist, führt program SCHEDULE wie folgt durch:

$$\textbf{program SCHEDULE (EVENT, K):}$$

$$(* \qquad K = (\phi_h, r, l, \underline{true}) \quad *)$$

$$\textbf{begin} \qquad\qquad\qquad (26)$$

```
1      insert (EVENT, K) into EVENTLIST;

2      if (EVENT = CEVENT) then

3          for h' > h do

4              for r' > r do                        (noch (26))
5                  if (CEVENT, (φ_h', r', 1, true)) EVENTLIST) then
6                      EVENTLIST:: = EVENTLIST/ (CEVENT,(φ_h', r', 1, true
7                  fi; (*5*)
8              od;
```

Hierbei stützt sich program SCHEDULE in Zeile 1 auf folgende Ordnungsrelation (" < ") für Ereigniskennungen: Seien K: = ($\phi$, r, l, true) und K': = ($\phi'$, r', l', true) zwei Ereigniskennungen, dann gelte ca.

$$(27)$$

$$K < K' \quad :\Leftrightarrow$$

$$\left( \left( \phi \neq \phi' \ \wedge \ \underset{t \in \phi}{\forall} : \underset{t' \in \phi'}{\forall} : \ t \leq t' \right) \ \vee \right.$$

$$(\phi = \phi' \ \wedge \ r < r') \ \vee$$

$$\left. (\phi = \phi' \ \wedge \ r = r' \ \wedge \ l < l') \right).$$

Diese Ordnungsrelation kann mit Hilfe eines 3-stufigen Systems geketteter Listen (Bezeichnung: EVENTLIST), wie es in Figur (4) dargestellt ist, realisiert werden: Es entsteht durch Erweiterung des von E.Ulrich als grundlegende Datenstruktur für die Ereignissteuerung in der diskreten Simulation vorgeschlagenen Systems horizontaler und vertikaler Listen (E.G.Ulrich, "Event Manipulation For Discrete Simulations Requiring Large Numbers Of Events", Communications of the ACM, vol. 21, Nr. 9, 1978, 777-785). Mit Hilfe der nach Figur (3) definierten Abhängigkeitsstruktur der Folgeereignisse eines Ereignisses und mit Hilfe den zugehörigen Verletzungsdaten $F_{in}$(..) und $F_{out}$(..) läßt sich der Parallelitätsgrad dieses Listensystems in Abhängigkeit von der Schaltungsbeschreibung bestimmen (A.T. Ambler, R.L. Manning, N. Muhammed, "Hardware Accelerators for CAD", Computer Aided Engineering Journal, Aug. 1985, 110 -117).

Mit Hilfe der Waveform Relaxation ist somit eine Einbettung der Analog-Simulation auf der Circuit-Ebene in ein diskretes, ereignisgesteuertes Simulationsverfahren, das den in der Logiksimulation angewendeten Verfahren sehr ähnlich ist, bereitgestellt.

Damit ist die Simulation elektrischer Schaltungen mit Hilfe der Ereignissteuerung auf der Circuit-Ebene beschrieben. Im folgenden wird die ereignisgesteuerte Simulation auf der Logik- bzw. Gatterebene beschrieben.

Schaltungssysteme werden auf der Gatterebene durch die Vernetzung von logischen Grundelementen, den Gattern, welche Schaltungsbausteine geringer logischer Komplexität repräsentieren, dargestellt. Das Spektrum derartiger Schaltungsbausteine wird dabei im allgemeinen in

- allgemeine logische Grundelemente (z.B. AND, OR, INVERT etc.) und in
- technologie-spezifische logische Grundelemente (z.B. MOS-Grundelemente)

unterteilt. Jedem Grundelement sind dabei Eingänge und Ausgänge entweder statisch (unidirektionale Elemente) oder dynamisch (bidirektionale Elemente) zugeordnet, deren Belegungen mit digitalen Zustandsfolgen das funktionale und zeitliche Verhalten des Gatters charakterisieren. Das Verhalten des gesamten Schaltungssystems ist dann implizit über die Vernetzung der Gatter bestimmt.

Basis der Modellierung des physikalischen Verhaltens von Schaltungen auf der Gatterebene ist eine Menge

$$(28) \quad B := \{b_l,...,b_m\}$$

von endlich vielen (digitalen) "logischen Werten". Im einfachsten Fall beinhaltet die Menge B nur die drei logischen Grundwerte

0     für Eingang/Ausgang "geschlossen"

1     für Eingang/Ausgang "offen"

x     für Eingang/Ausgang "undefiniert".

Um eine differenziertere und realistischere Nachbildung der Schaltungseigenschaften von Gattern zu erhalten, werden die logischen Grundwerte mit geeignet definierten Signalstärken überlagert und ihnen zusätzlich der Tristate-Wert (hochohmig) beigefügt. Unter einer digitalen Zustandsfolge versteht man nun eine auf einem global vorgegebenen äquidistanten Zeitraster

$$T^{\#} := \Delta t \cdot N_0 \text{ (mit } \Delta t \in R) \text{ } ^{1)} \qquad (29)$$

für die Zeitachse $(0, \infty)$ definierte Funktion

$$(30) \qquad z : \quad T^{\#} \quad \rightarrow \quad B$$
$$t \quad \mapsto \quad z(t).$$

Darauf aufbauend ist ein logisches Grundelement G wie folgt definiert:

$$(31) \quad G := (X_G, Y_G, f_G, d_G)$$

wobei

$$(32) \quad \begin{aligned} X_G &\subset \mathbb{N}, \ X_G \neq \emptyset, \ x := |X_G| \geq 1, \\ Y_G &\subset \mathbb{N}, \ Y_G \neq \emptyset, \ y := |Y_G| \geq 1, \\ X_G &\cap Y_G = \emptyset. \end{aligned}$$

und

$$(33) \quad f_G \quad : \quad B^x \quad \rightarrow \quad B^y \quad ,$$

$$(z_\xi)_{\xi \in X_G} \quad \mapsto \quad (z_\zeta)_{\zeta \in Y_G} \quad := \quad f_G((z_\xi)_{\xi \in X_G})$$

$$(34) \quad d_G \quad : \quad B^x \quad \times \quad B^x \quad \rightarrow \quad T^\#$$

$$((z_\xi)_{\xi \in X_G}, (z_\xi)_{\xi \in X_G}) \quad \mapsto \quad t_d \quad := \quad d_G(\dots,\dots)$$

dabei heißt

| | | |
|---|---|---|
| $X_G$ | Menge der Eingänge von G, | |
| $Y_G$ | Menge der Ausgänge von G, | |
| $f_G$ | Gatterfunktion, | (35) |
| $d_G$ | Delay-Funktion, | |
| $t_d$ | Delay (Verzögerungszeit). | |

Das dynamische Verhalten eines Gatters G, d.h. die Zuordnung von Zustandsfolgen

$$(36) \quad\quad y_G(t) \quad := \quad (z_\zeta(t))_{\zeta \in Y_G}, t \in T^\#$$

zu den Ausgängen $Y_G$ von G in Abhängigkeit von gegebenen Zuständen

$$(37) \quad\quad x_G(t) \quad := \quad (z_\xi(t))_{\xi \in X_G},$$

an dessen Eingängen, liefert dann folgendes Proramm.

```
program  GATE (G):

1     begin

2         t_0 := 0 ;

3         t_1 := Δt ;                                    (38)

4         get(x_G(t_0), x_G(t_1)) ;

5         w := f_G(x_G(t_1)) .              (* Funktionsauswertung *)

6         t_d := d_G(x_G(t_0), x_G(t_1)) ;      (* Delay-Bestimmung *)

7         y_G(t_1 + t_d) := w ;

8         t_0 := t_1 ;

9         t_1 := t_1 + Δt ;

10    goto 4 ;

11    end.
```

Das Programm GATE (G) erzeugt wegen der Verzögerungszeiten eine Zustandsfolge yG (t) für die Ausgänge YG von G, die im allgemeinen nur für

(39)    $t \in T^* \text{ mit } T^* \subset T^\#, T^* \neq T^\#$

definierte Werte enthält. Für die Zwischenwerte $t \in T^\# \backslash T^*$ erhält man die Werte für z(t) durch konstante Fortsetzung, d.h. durch die Funktion

```
                                   function CONT (G, T*, t):

                          1     begin

                          2         if (t ∈ T# \ T*) then

(40)                      3             t* ::= max { t' ∈ T* : t' < t } ;

                          4             CONT ::= y_G(t*) ·

                          5         fi ;

                          6     end ; .
```

Die Vernetzung der einzelnen Gatter untereinander erhält man schließlich wie folgt:

Seien G: = (XG, YG, fG, dG) und H: = (XH, YH, FH, DH) zwei verschiedene Gatter, dann heißen G und H vernetzt, wenn

20

$$\exists \qquad : \qquad \exists \qquad : \qquad \zeta = \xi \qquad (41a)$$
$$\zeta \in Y_G \qquad \xi \in X_H$$

oder

$$\exists \qquad : \qquad \exists \qquad : \qquad \zeta = \xi . \qquad (41b)$$
$$\zeta \in Y_H \qquad \xi \in X_G$$

Durch die beiden Bedingungen (41a)und (41b) werden zwei gegenläufige Verarbeitungsrichtungen für Zustandsfolgen definiert, die den Signalfluß in einem System vernetzter Gatter charakterisieren; im folgenden wird dafür folgende Schreibweise benutzt:

$$(42) \qquad H \quad = \quad \mathrm{succ}\,(G) \qquad : \Leftrightarrow \qquad (41) \qquad \mathrm{gilt},$$
$$G \quad = \quad \mathrm{pred}\,(H) \qquad : \Leftrightarrow \qquad (41) \qquad \mathrm{gilt},$$

Ein Netzwerk (Schaltungssystem) ist dann durch

$$(43) \qquad C^{\#} := (G^{\#}, N^{\#})$$

gegeben, wobei $G^{\#}$ eine Menge von vernetzten Gattern bezeichnet und $N^{\#}$ die zugehörige Netzliste der Form

$$(44) \quad N^{\#} = \{(G, F_{in}(G), F_{out}(G)) : G \in G^{\#} \}$$

mit

$$(45) \qquad F_{in}(G) := \{H \in G^{\#} : H = pred(G)\},$$

$$(46) \qquad F_{out}(G) := \{H \in G^{\#} : H = succ(G)\}$$

darstellt.

Um das dynamische Verhalten eines großen Schaltungssystems $C^{\#} = (G^{\#}, N^{\#})$ effizient auf der Gatterebene simulieren zu können, ist die zeitlich schwache Aktivität der einzelnen Gatter auszunutzen. Dazu wird die Anzahl der Auswertungen der Gatterfunktionen (gemäß der Zeilen 4, 5, 6, 7 von progam GATE (...) aus (38)) mit Hilfe der folgenden Prinzipien auf ein Mindestmaß reduziert:
- es werden nur Zustandsänderungen an den Ausgängen der Gatter betrachtet.
- Die Weiterleitung der Zustandsänderungen von den Gatterausgängen zu den Eingängen nachfolgender Gatter erfolgt gemäß der Netzliste des Schaltungssystems.

Es werden nur diejenigen Gatter ausgewertet, an denen sich wenigstens ein Eingangszustand geändert hat; die Berechnungsreihenfolge wird durch ein Listensystem gesteuert, das nach Kennungen angeordnet ist, die die Auswertungsprozesse (Ereignisse, EVENTS) hinsichtlich der zugehörigen Ereigniszeiten und Gatter charakterisieren.

Eine formale Definition des Begriffs Ereignis erhält man damit durch ein Programm folgender Bauart.

$$\textbf{program} \ \ \textrm{LEVENT}\,(K):$$

$$\textbf{begin}$$

(47)

$$A$$

$$\textbf{end} \ .$$

Der Parameter K heißt Ereigniskennung, das Programmstück A heißt Ereignisauswertung. Es gelten dafür folgende Definitionen:

(48)  $K := (t,G,b),$

wobei $t \in T^{\#}, G := (XG, YG, fG, dG)$ ein Gatter ist und
$b \in \{\text{true, false}\}$ die Aktivität des Gatters G bei t anzeigt.

(49)

$$A:$$

```
1    if b  then
2        get ( F_in (G) , F_out (G) ) ;
3        update  x_G (t - Δt) , x_G (t)  by use of  y_H(s) , s ∈ T* (H) , H ∈ F_in (G) ;
4        w  :=    f_G (x_G (t) ) ;
5        t_d  :=  d_G (x_G (t - Δt) , x_G (t) ) ;
6        t_1  :=  t + t_d
7        y_G (t_1 - Δt)  :=  CONT (G, T* (G) , t_1 - Δt) ;
8        if (w ≠ y_G (t_1 - Δt) ) then
9            y_G (t_1) :=  w ;
10           T* (G) := T* (G) ∪ { t_1 } ;
11           for H ∈ F_out (G) do
12               execute SCHEDULE( LEVENT, (t_1, H, true ) );
13           od ;
14       fi ;  (* 8 *)
15   fi ;  (* 1 *) .
```

Hierbei bezeichnet $T^* \subset T^{\#}$ die Menge der "Ereigniszeiten des Gatters G", die durch

(50)  $T^* (G) := \{0\}$

initialisiert ist und durch jede Ausführung von program LEVENT ((t,G,true)) um den Wert t sukzessive erweitert wird. Es wird vorausgesetzt, daß die Werte von XG(t) und YG(t) für alle G aus $G^{\#}$ zur Zeit t = 0 bestimmt sind.

Die Ausführung eines Ereignisses führt in Abhängigkeit von der Bedingung aus (49) Zeile 8, zu Folgeereignissen (vgl. (49), Zeile 12), deren Einordnung in eine korrekte Verarbeitungsreihenfolge mit program SCHEDULE (s. (26)) anhand folgender Ordnungsrelation " " für Ereigniskennungen geschieht: Seien K: = (t, G, true) und K: = (t; G; true) gemäß (48) erklärt, dann gelte

$$(51)$$

$$K < K' \quad :\Leftrightarrow$$

$$( (t < t') \quad \lor$$

$$(t = t' \quad \land \quad \exists \quad : G' = \mathrm{succ}(G_p) = ... = \mathrm{succ}(G_1) = \mathrm{succ}(G) \quad ) ).$$
$$G_1, ..., G_p \in G^{\#}$$

Diese Ordnungsrelation kann mit Hilfe eines zweidimensionalen Systems (Bezeichnung: EVENTLIST) verketteter Listen, wie es in Figur (4) dargestellt ist, realisiert werden (Ulrich 1978).

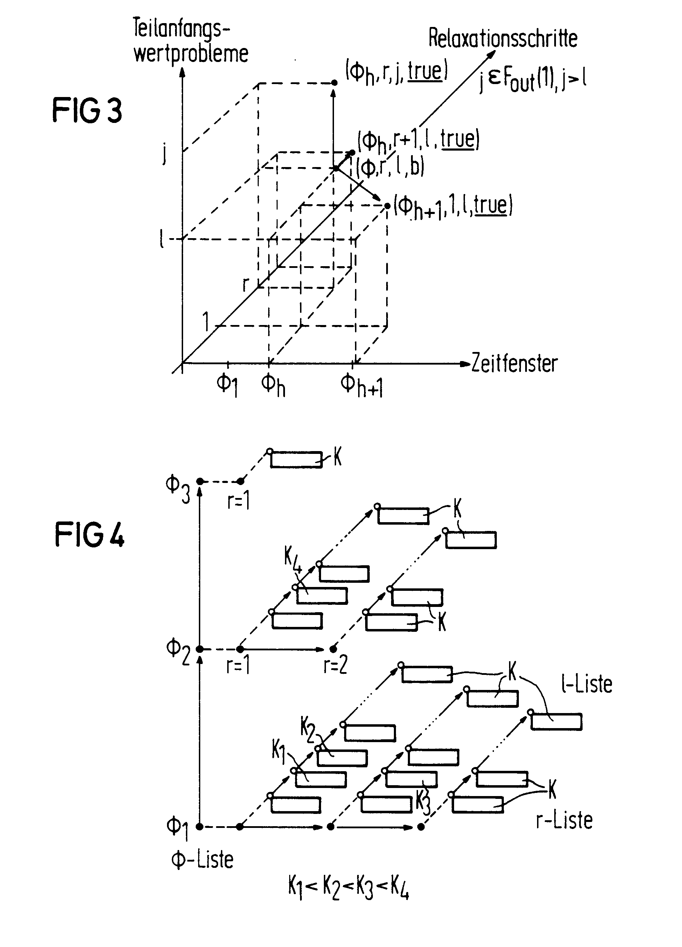

Eine Analogie zu der Ordnungsrelation (27) und zu den zugehörigen Listensystem (Figur 4) für die ereignisgesteuerte Simulation auf der Circuitebene erhält man bei Ergänzung von r = 1 durch folgende Zuordnung für Kennungen von Ereignissen der Simulation auf der Gatterebene und auf der Circuitebene:

$$\mathrm{erg\ddot{a}nzt}$$
$$\downarrow$$

$$(52) \qquad \mathrm{gate\ level:} \qquad K_L = ( t, 1, G, b )$$

$$\updownarrow \updownarrow \updownarrow \updownarrow$$

$$\mathrm{circuit\ level:} \qquad K_C = ( \phi_n, r, 1, b )$$

Die ereignisgesteuerte Simulation wie sie für die Circuitebene und die Gatterebene dargestellt worden sind, weisen zwei für ihre Kopplung wesentliche Unterscheidungsmerkmale auf:

- Zustandswerte
- Zeitbehandlung

Die gegenseitige Anpassung der Zustandswerte aus unterschiedlichen Wertemengen (Spannungen/logische Werte), die bei der Kopplung von Schaltungselementen der Circuitebene und der Gatterebene notwendig ist, kann durch die Zwischenschaltung von sog. Pseudoelementen erfolgen, welche die logischen Grundwerte 0,1,x in geeignete Spannungswerte und die zugehörigen Signalstärken in geeignete Konduktanzwerte bzw. Spannungswerte und Konduktanzwerte in geeignete logische Grundwerte und Signalstärken verzögerungsfrei transformieren (G.Arnout,H.J. Deman, The Use of Threshold Functions and Boolean-Controlled Network Elements for Macro-modelling of LSI-Circuits, IEEE J.Solid State Circuits, vol. SC-13, Juni 1978, 326-332), A.R.Newton, "Techniques of the Simulation of Large Scale Integrated Circuits", IEEE Trans. Circuits and Systems, vol. CAS-26, No. 9, Sept. 1979, 741-749). Diese Pseudoelemente sind dann als zusätzlche Schaltungselemente in Gattermenge G und die Netzliste N des gegebenen Schaltungssystems $C^{\#} = (G^{\#}, N^{\#})$ aufzunehmen, und in der oben beschriebenen Art und Weise in einer ereignisgesteuerten Simulation dieses Schaltungssystems zu behandeln.

Für die Anpassung der unterschiedlichen Methoden der Zeitbehandlung (kontinuierlich/diskret) der Simulationsmethoden im Rahmen einer gemeinsamen ereignisgesteuerten mixed-mode Simulation sind zwei verschiedene Ansätze möglich:

A) Anpassung der ereignisgesteuerten Simulation auf der Gatter-Ebene an die ereignisgesteuerte Waveform Relaxation auf der Basis der in (14) definierten Zeitfenster, in dem für jedes Gatter alle Zustandsänderungen auf einem Zeitfenster $\phi_h$ zu einem Ereignis zusammengefaßt werden (d.h. Auswertung von program LEVENT ((t,G,b)) für alle $t \in \phi_h \cap T^\#$ für die gilt: b = true.

B) Anpassung der ereignisgesteuerten Simulation auf der Circuitebene an die ereignisgesteuerte Simulation auf der Gatterebene auf der Basis von diskreten Ereigniszeitpunkten in dem das in (A.Sakallah, S.W.Director, "An event-driven VLSI Circuit Simulator", IEEE Trans. Computer-Added Design, vol. CAD-4, Nr. 4 Oct. 1985, 668 bis 684) dargestellte Verfahren für die Simulation auf der Circuitebene herangezogen wird.

Liegt ein rückkopplungsfreies Schaltungssystem vor, so liefert der Ansatz A (insbesondere bei der Berücksichtigung von Laufzeiten (td > 0 in (34)) ein effizienteres Simulationsverfahren auf der Gatterebene als der Ansatz B.

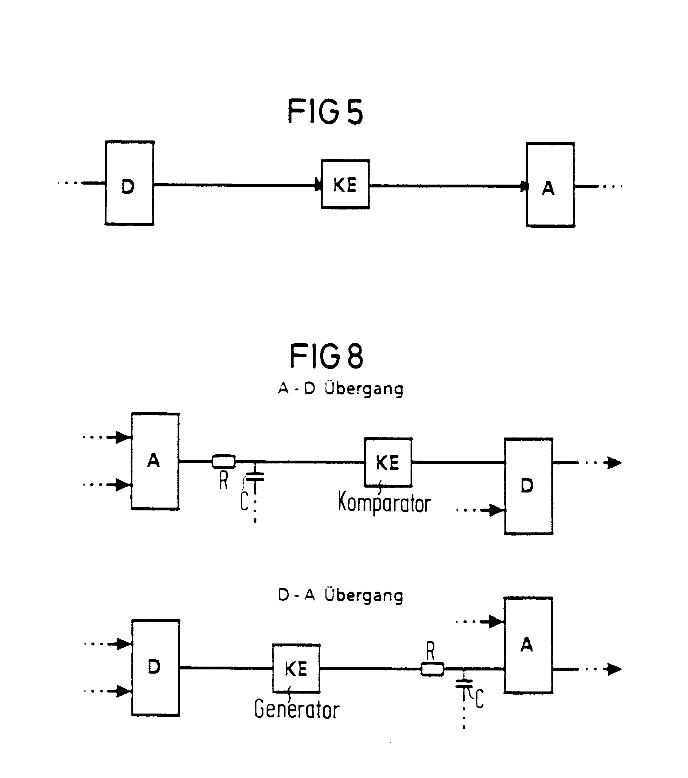

Zur Schnittstellenanpassung zwischen digital simulierten bzw. analog simulierten Schaltungsteilen sind Koppelelemente vorgesehen, welche einer Signaltransformation zwischen digital simulierten bzw. analog simulierten Schaltungsteilen vornehmen. Hierbei wird jede Leitung bzw. jedes Signal getrennt umgesetzt. Innerhalb der Modellbeschreibung legt der Anwender die gewünschten Schnittstellen (eventuell unter Angabe von Technologie-Parametern) fest. Bei der Vorbereitung der Simulation werden dann an allen Schnittstellen zwischen analog simulierten bzw. digital simulierten Schaltungsteilen geeignete Koppelelemente eingefügt, welche die Beschreibungen der jeweiligen Umsetzfunktionen enthalten. Figur 5 zeigt die Einfügung eines Koppelelementes KE zwischen einem digital simulierten Schaltungselement D und einem analog simulierten Schaltungselement A.

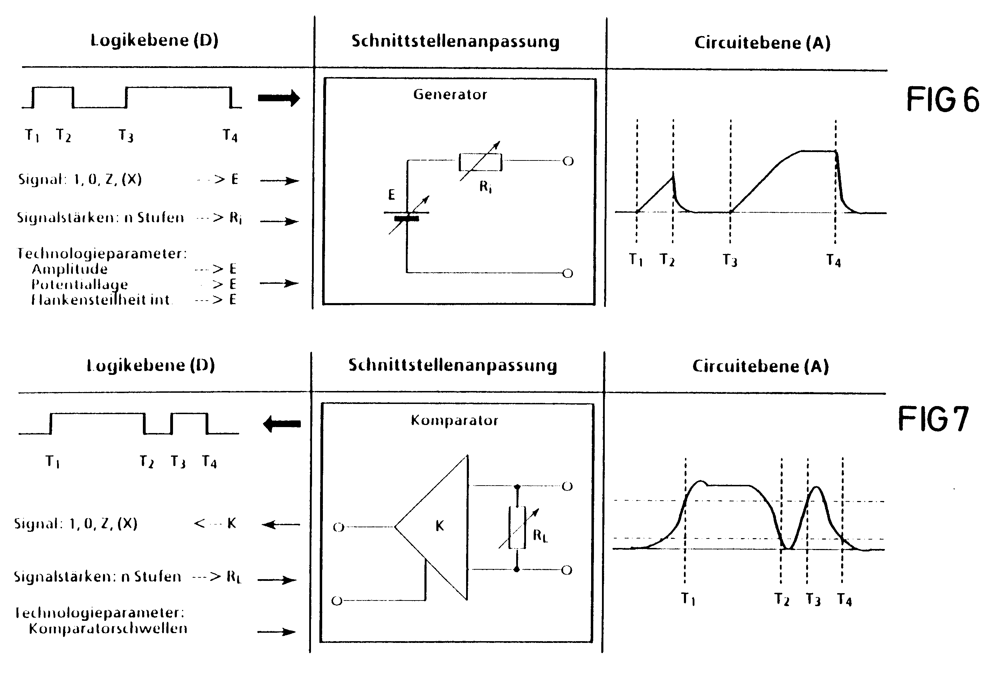

Je nach Richtung der Signaltransformation (digital-analog oder analog-digital) ist ein bestimmter Typ eines Koppelelementes nötig. Die beiden erforderlichen Typen werden als Generator bzw. Komparator bezeichnet. Wie in Figur 6 dargestellt, werden zu jedem Ereigniszeitpunkt digitale Eingangsbedingungen an einen Generator angelegt. Solche digitalen Eingangsbedingungen sind Zustandsübergänge, z.B. Übergänge zwischen 1, 0 oder X mit entsprechenden Signalstärken. Mit Hilfe des Generators wird auf diese Weise ein analoges Ausgangssignal erzeugt, welches von dem digital simulierten Schaltungselement D erzeugt worden wäre, wenn es analog simuliert worden wäre. Zu diesem Zweck wird der Generator vorzugsweise als steuerbare Spannungsquelle E mit steuerbarem Innenwiderstand $R_i$ modelliert. Die Spannung E und der Innenwiderstand $R_i$ ergeben sich dabei aus dem digitalen Signal selbst, den Signalstärken sowie den vom Anwender spezifizierten Technologieparametern (Signalamplitude, Potentiallage, Flankensteilheit).

Figur 7 zeigt die Arbeitsweise eines Komparators, also eines Koppelelements für den umgekehrten Vorgang der Schnittstellenanpassung zwischen dem Ausgang eines analog simulierten Schaltungselements und dem Eingang eines digital simulierten Schaltungselements. Der Komparator bewertet eine analoge Signalfunktion und generiert Zustandsübergänge, z.B. Übergänge zwischen 1, 0 und X und Ereigniszeitpunkte, wenn definierte Komparatorschwellen über definierte Signalstärken über- oder unterschritten werden. Zu diesem Zweck ist der Komparator eingangsseitig mit einem parallel geschalteten regelbaren Lastwiderstand $R_L$ versehen, dessen Widerstandswert sich aus den Signalstärken ergibt. Die Komparatorschwellen, also diejenigen analogen Signalwerte, bei welchen der Komparator Zustandsübergänge erzeugt, sind technologieabhängige Parameter und werden vom Anwender vorgegeben.

Beim Generator (Figur 6) bildet die analogbeschriebene Ausgangsstufe den Leitungsabschluß für die anschließende analoge Schaltungsbeschreibung und stellt gleichzeitig den Innenwiderstand des Generators dar. Die idealen Flanken des digitalen Signals werden auf normierte Flanken transformiert, die elementtypisch (z.B. Leistungsgatter) und technologiespezifisch (z.B. TTL) sind.

Beim Komparator bildet die analog beschriebene Eingangsstufe den Leitungsabschluß für die davor liegende analoge Schaltungsbeschreibung und stellt gleichzeitig den Lastwiderstand des Komparators dar. Sind die Bedingungen der Komparatorstellen erfüllt, so wird für den jeweiligen Zustandsübergang die ideale Flanke erzeugt. Für jeden auszuwertenden Zustand müssen spezifische Komparatorschwellen, spezifische Lastwiderstände und eventuelle Abhängigkeiten von anderen Zuständen definiert werden.

Auf der Verbindung zwischen einem digitalen Element D und einem analogen Element A können diskrete Bauteile oder Ersatzwerte für den Widerstands- und Kapazitätsbelag von Verbindungsleitungen angeordnet sein. Die Koppelelemente KE werden dann stets so eingefügt, daß die diskreten Bauteile immer der Seite mit analoger Beschreibung zugeschlagen werden (Figur 8).

Bei der Mixed-mode Simulation ist es erforderlich, in einer Schaltung freizügig Bereiche abzugrenzen, die analog beschrieben und simuliert werden. Dabei kann es vorkommen, daß ein Ausgangssignal eines Schaltungselements zu mehreren Folgeelementen führt, von denen ein Teil digital und der andere Teil analog beschrieben und simuliert wird. Die für einen Digital-Analog-Übergang bzw. einen Analog-Digital-Übergang typischen Verzweigungen zeigen die Figuren 9 und 10. Da die analoge Beschreibung stets die größere Genauigkeit hat, werden die elementbezogenen Koppelelemente mit Vorteil stets so angeordnet, daß die analogen Schaltungsteile stets das gesamte Leitungsnetzwerk "sehen". Dadurch ist gewährleistet,

EP 0 481 117 A1

daß die analogen Schaltungsteile sich in der Simulation in der Gesamtschaltung nicht anders verhalten, als wenn die Gesamtschaltung analog simuliert würde, weil bezüglich der fan-in bzw. fan-out Bilanz kein Fehler auftritt.

**Patentansprüche**

1. Verfahren zur Simulation elektronischer Schaltungen und Systeme für Zwecke des rechnergestützten Entwurfs solcher Schaltungen und Systeme mit folgenden Merkmalen:
    a) Verschiedene Teilschaltungen einer zu simulierenden Gesamtschaltung die jeweils auf einer von mehreren verschiedenartigen Schaltungsbeschreibungsebenen beschrieben sind, werden jeweils einer von mehreren verschiedenartigen Simulationsebenen zugeordnet;
    b) die zu simulierende Gesamtschaltung wird auf allen Simulationsebenen gleichzeitig simuliert;
    c) die Simulation wird nach dem Prinzip der Ereignissteuerung durchgeführt.

2. Verfahren nach Anspruch 1,
   dadurch **gekennzeichnet,**
   daß zur Ereignissteuerung ein System von Ereignislisten generiert und dynamisch, d.h. in Abhängigkeit vom Verlauf der Simulation, verwaltet wird.

3. Verfahren nach Anspruch 2,
   dadurch **gekennzeichnet,**
   daß während der Simulation im Ereigniszyklus (S2, S3, S4, S5 und S6) Ereignisse dynamisch erzeugt und nach einer durch das System von Ereignislisten gegebenen Reihenfolge bearbeitet werden.

4. Verfahren nach Anspruch 3,
   dadurch **gekennzeichnet,**
   daß der Bearbeitungsschritt "Auswerten eines Elements" (S3) nur auf Daten des betreffenden Elements (D1) zugreift und unabhängig von anderen Bearbeitungsschritten ausgeführt wird.

5. Verfahren nach einem der vorhergehenden Ansprüche,
   dadurch **gekennzeichnet,**
   daß zur Simulation ein heterogenes Zeitraster verwendet wird.

6. Verfahren nach einem der vorhergehenden Ansprüche,
   bei dem digitale Schaltungsteile mit analogen Schaltungsteilen über Koppelelemente zur Signaltransformation verbunden werden.

7. Verfahren nach Anspruch 6,
   dadurch **gekennzeichnet,**
   daß Koppelelemente zwischen Ausgängen digital simulierter Schaltungselemente und Eingängen analog simulierter Schaltungselemente als variable Spannungsquellen mit variablem Innenwiderstand modelliert werden.

8. Verfahren nach Anspruch 6,
   dadurch **gekennzeichnet,**
   daß Koppelelemente zwischen Ausgängen analog simulierter Schaltungselemente und Eingängen digital simulierter Schaltungselemente mit Hilfe von Schwellwertentscheidern und variablen Lastwiderständen modelliert werden.

9. Verfahren nach Anspruch 6,
   dadurch **gekennzeichnet,**
   daß Koppelelemente zwischen analog simulierten und digital simulierten Schaltungsteilen stets so eingefügt werden, daß diskrete Bauelemente, wie z.B. Widerstände und Kapazitäten, sich zwischen dem Koppelelement und dem analogen Schaltungsteil befinden.

10. Verfahren nach Anspruch 6,
   dadurch **gekennzeichnet,**
   daß Koppelelemente in Gesamtschaltungen aus analogen und digitalen Schaltungsteilen stets so

25

eingefügt werden, daß die Koppelelemente zwischen den digital simulierten Schaltungsteilen und dem Leitungsnetz eingefügt sind, und daß Ersatzschaltungen zur Modellierung des physikalischen Verhaltens des Leitungsnetzes stets direkt mit den analog simulierten Schaltungsteilen verbunden sind.

**FIG1**

S1

S2

X₁

S3

X₂

S4

S5

S6

S7

D1

D2

D3

**FIG2**

(1)

Iteration über die Zeitfenster $\Phi_h$, h=1,...,H
  (2) für jedes h:

Iteration der Relaxationsschritte r,
r = 0,1,2,...
    (3) für jedes r:

Iteration über die Teilsysteme fη,
l =0,1,2,...
      (4) für jedes l, falls r=0:

Algorithmus "Waveform Relaxation", Zeile 3

      (5) für jedes l, falls r>0:

Algorithmus "Waveform Relaxation", Zeilen 8,9

FIG 3

Teilanfangs-wertprobleme

$(\Phi_h, r, j, \underline{true})$

Relaxationsschritte

$j \in F_{out}(1), j > l$

$(\Phi_h, r+1, l, \underline{true})$

$(\Phi, r, l, b)$

$(\Phi_{h+1}, 1, l, \underline{true})$

$j$

$l$

$r$

$1$

Zeitfenster

$\Phi_1$    $\Phi_h$    $\Phi_{h+1}$

FIG 4

$\Phi_3$   $r=1$   K

$K_4$   K

$\Phi_2$   $r=1$    $r=2$

$K_2$   K   l-Liste

$K_1$

$K_3$   K   r-Liste

$\Phi_1$

$\Phi$-Liste

$K_1 < K_2 < K_3 < K_4$

# FIG 5

# FIG 8

A - D Übergang

Komparator

D - A Übergang

Generator

| Logikebene (D) | Schnittstellenanpassung | Circuitebene (A) |
| --- | --- | --- |

FIG 6

$T_1$  $T_2$   $T_3$        $T_4$

Generator

Signal: 1, 0, Z, (X)        ---> E

Signalstärken: n Stufen  ---> $R_i$

$R_i$

E

Technologieparameter:
  Amplitude        ---> E
  Potentiallage      > E
  Flankensteilheit int.  ---> E

$T_1$  $T_2$   $T_3$        $T_4$

| Logikebene (D) | Schnittstellenanpassung | Circuitebene (A) |
| --- | --- | --- |

FIG 7

$T_1$        $T_2$  $T_3$  $T_4$

Komparator

Signal: 1, 0, Z, (X)        < --- K

K

$R_L$

Signalstärken: n Stufen  ---> $R_L$

Technologieparameter:
  Komparatorschwellen

$T_1$            $T_2$  $T_3$  $T_4$

EP 0 481 117 A1

# FIG 9

D - A Übergang

Generator

Komparator

# FIG 10

A - D Übergang

**Europäisches Patentamt**

**EUROPÄISCHER RECHERCHENBERICHT**

Nummer der Anmeldung

**EP 90 12 0006**

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.5) |
|---|---|---|---|
| X | PROCEEDINGS OF THE 1989 EUROPEAN MULTICONFERENCE, Rome, 7. - 9. Juni 1989, Seiten 355-360; K.E. JACOBY et al.: "Basic concepts for hardware acceleration for mixed-mode simulation" <br> * Das ganze Dokument * <br> – – – | 1-10 | G 06 F 15/60 |
| A | COMPUTER DESIGN, Band 27, Nr. 3, Februar 1988, Seiten 57-65, Littleton, MA, US; R. GOERING: "A full range of solutions emerge to handle mixed-mode simulation" <br> * Seite 59, Spalte 1, Zeilen 9-20; Seite 62, Spalte 2, Zeile 39 - Seite 63, Spalte 1, Zeile 6; Seite 64, Spalte 2, Zeilen 2-5 * <br> – – – | 1,6,7,8 | |
| A | IEEE INTERNATIONAL CONFERENCE ON COMPUTER-AIDED DESIGN, ICCCAD-87, Santa Clara, CA, 9. - 12. November 1987, Seiten 488-481; C.M. DYSON et al.: "A pipelined event-driven mixed-mode simulator" <br> * Zusammenfassung; Seite 491, Spalte 1, Zeile 19 - Spalte 2, Zeile 17; Figur 6 * <br> – – – | 1,6,7,8 | |
| A | PROCEEDINGS 1988 INTERNATIONAL CONFERENCE ON COMPUTER DESIGN: VLSI IN COMPUTERS AND PROCESSORS, ICCD'88, New York, 3. - 5. Oktober 1988, Seiten 120-123; A.C.J. STROUCKEN et al.: "MILES: A mixed level simulator for analog/digital design" <br> * Zusammenfassung; Figur 1 * <br> – – – | 1 | **RECHERCHIERTE SACHGEBIETE (Int. Cl.5)** <br><br> G 06 F 15/60 <br> G 06 J 1/00 |
| A | EP-A-0 381 332   (TEXAS INSTRUMENTS) <br> * Seite 2, Zeile 52 - Seite 3, Zeile 4; Seite 6, Zeilen 27-29 * <br> – – – – – | 1,6,7,8 | |

Der vorliegende Recherchenbericht wurde für alle Patentansprüche erstellt

| Recherchenort | Abschlußdatum der Recherche | Prüfer |
|---|---|---|
| Den Haag | 28 Juni 91 | GUINGALE A. |